Europäisches Patentamt

European Patent Office

Office européen des brevets

(11) Publication number: **0 302 511 B1**

## EUROPEAN PATENT SPECIFICATION

(45) Date of publication of patent specification: **29.12.93**

(51) Int. Cl.5: **H03M 13/12**, H03M 13/00

(21) Application number: **88112785.6**

(22) Date of filing: **05.08.88**

(54) Sequential decoder having a short resynchronization interval.

(30) Priority: **07.08.87 JP 197682/87**
**20.10.87 JP 265643/87**

(43) Date of publication of application:
**08.02.89 Bulletin 89/06**

(45) Publication of the grant of the patent:
**29.12.93 Bulletin 93/52**

(84) Designated Contracting States:
**DE FR GB**

(56) References cited:
**EP-A- 0 139 511**
**US-A- 3 665 396**
**US-A- 3 872 432**
**US-A- 4 539 684**
**US-A- 4 583 078**

**IEEE TRANSACTIONS ON INFORMATION
THEORY. vol. 9, April 1963, NEW YORK US
pages 64 - 74; ROBERT M. FANO: "A HEURIS-
TIC DISCUSSION OF PROBABILISTIC DE-
CODING"**

(73) Proprietor: **NEC CORPORATION**
**7-1, Shiba 5-chome**
**Minato-ku**
**Tokyo 108-01(JP)**

(72) Inventor: **Yagi, Toshiharu**
**c/o NEC Corporation**
**33-1, Shiba 5-chome**
**Minato-ku Tokyo(JP)**

(74) Representative: **VOSSIUS & PARTNER**
**Postfach 86 07 67**
**D-81634 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.10/3.6/3.3.1)

## Description

The present invention relates generally to a sequential decoder for decoding convolutional codes.

In order to detect errors in transmitted data bits and correct the data bits in error, the current practice involves segmenting data to be transmitted into several information symbols and converting them into convolutionally coded symbols using a forward error correction encoder and decoding transmitted symbols by an error correction decoder according to an algorithm which is known as the Fano algorithm.

According to the Fano algorithm developed by R. M. Fano and described in IEEE Transactions on Information Theory, IT-9 (1963), pages 64-74, the error correction encoder is provided with a state holding circuit and a function generator. The state holding circuit is typically composed of a shift register which retains its internal state but changes its state when it receives an information symbol. The function generator receives the internal state of the shift register to generate a coded symbol. The signal received by the decoder for hard-decision decoding does not necessarily match what is actually transmitted due to lost or corruption of data bits during transmission or due to indefiniteness present in the amplitude levels of demodulated QAM or PSK signals resulting from phase errors introduced to the recovered carrier.

If the decoder performs its decoding step on a per symbol basis, the decoder can be said to have the same circuit function as the error correction encoder, or a "replica of the encoder". On receiving a coded symbol, the decoder compares it with each of information symbols which can be obtained by the replica of the encoder if it were to receive all possible information symbols and assumes an information symbol that is nearest to the received symbol as transmitted, The yardstick for measuring the distance to the nearest coded symbol is the Fano likelihood which is currently employed. According to the Fano algorithm, an information symbol sequence which gives the largest cumulative value is assumed to be the most likely message sequence.

If a large number of transmission errors should occur, there is a possibility that the decoder makes a false decision. After having taking a wrong decision, the discrepancies between the internal states of the encoder replica and those in the encoder grow much more rapidly than would be the case if the decoder were following the correct path, and all subsequent attempts would fail to find symbols having a large Fano likelihood value, thus making it possible to detect that a false decision has been made in the past. On detecting a false decision, the decoder retraces its path to return the internal states of the encoder replica to a point where the false decision was made and takes an alternate path that gives the next largest cumulative value of the Fano likelihood and performs a decoding step on the selected path. If the decoder should fall in the search, it retraces further back to a past state to repeat the process. In this way, the decoder attempts to search for a correct path on the basis of trial and error. Since the past histories are retraced in the sequential decoder, the input and output symbols are stored in buffers.

The error correction encoder and decoder mentioned above can be implemented by a circuit shown and described in United States Patent 3,665,396 issued to George David Forney, Jr.

In order to achieve the comparison between the output symbols of the encoder replica and the input symbols to that replica, the decoder must be able to detect the starting and ending points of each coded symbol on which the comparison is performed. Stated otherwise, the comparison should be performed in synchronism with each received coded symbol. Since the received symbol does not usually contain timing information, such as sync codes, the prior art sequential decoder performs the following code resynchronization process on a trial and error basis.

Since out-of-sync conditions can result in a situation which is equivalent to the occurrence of a serious transmission error, the decoding process encounters a substantially delay, tending to overflow the buffers. Such overflow conditions can therefore be taken as an indication of the occurrence of an out-of-sync condition On detecting a buffer overflow, the decoder shifts the sync timing by one symbol bit before proceeding to decode on a trial basis a fresh symbol entered next into the input buffer. If this trial attempt still does not work to alleviate the overflow, the same process is repeated. Assume that each coded symbol is made up of $n$ coded bits, there are $n$ possible states which can be retraced to reestablish synchronism. Thus, a maximum of $(n-1)$ trial attempts eventually enables the decoder to reestablish synchronism. If the decoder should fall in advancing its decoding process further possibly due to out-of-sync, a single trial attempt for resynchronization will require the input buffer to store a maximum number of symbols that can be stored therein. The maximum amount of time taken to resynchronize the decoder is therefore $(n-1)$ times the interval taken to store the maximum number of symbols into the input buffer. In addition, whole symbols stored in the input buffer must be discarded wherever a resynchronization is attempted.

US-A-4,539,684 relates to a digital communications system using a convolutional encoding and decoding technique to minimize transmission time and decoding time. An autosynchronization sequence stored in a first memory is modulo-2 summed with a convolutional code sequence by an adder and presented to a bit interleaver which scrambles the information and parity bits to add time diversity so that relatively short burst errors may be corrected at the receiver. At the receiver, the transmitted data is selected by a selector with the best phase, bit-deinterleaved and modulo-2 summed with an autosynchronization sequence stored in a second memory to remove the transmitted autosynchronization sequence if the correct phase is selected. A modified sequential decoder controls the selector, bit-deinterleaver and memory to select the best phase.

As described above, the resynchronization attempt of the prior art sequential decoder can therefore take as long as ($n$-1) times the length of whole storage time of the input buffer. Therefore, no input data can be received during that interval.

It is therefore an object of the present invention to provide a sequential decoder which resynchronizes with an incoming data stream in a shorter period of time than is attainable with prior art sequential decoders.

This object is solved by the features of claim 1.

The sequential decoder of the present invention particularly comprises first and second buffers, or random access memories, and a decoder coupled to the first and second buffers for decoding a symbol bidirectionally supplied from the buffers in synchronism with a clock pulse occurring at a rate higher than the transmission rate of the symbol. An address circuit is connected to the first and second buffers for writing the received convolutionally coded symbols into the first buffer at the transmission rate, reading symbols out of the first buffer storage means into the decoder and writing symbols decoded by the decoder into the second buffer. A controller determines the likelihood of each symbol decoded by the decoder in accordance with a predetermined likelihood algorithm to cause the address circuit to read decoded symbols in a backward direction out of the second buffer into the decoder when the determination results in a low likelihood value. The controller detects an overflow condition of the first buffer when a first predetermined number M1 of locations of the first buffer are filled with received symbols. In response to the detection of the overflow condition, the controller causes the address circuit to read symbols out of the first buffer into the decoder starting with a symbol spaced by M1-M2 symbols form a most recently received symbol and causes the decoder to repeatedly perform decoding, upon detection of the overflow condition, on a symbol which is shifted by one clock interval, where M2 is a second predetermined number which is smaller than the first predetermined number M1. Specifically, the first predetermined number represents the capacity or maximum number of locations of each buffer.

In a first aspect of the present invention, an out-of-sync condition can be detected by the detection of the buffer overflow.

In a second aspect, a phase error introduced to a recovered carrier can be compensated for by a phase switching circuit which varies the logic level of the received symbols by an amount corresponding to a predetermined phase shift immediately following the detection of the buffer overflow.

In a specific aspect, the address circuit comprises a first address counter for incrementing a first address count in response to receipt of each of the convolutionally coded symbols and storing each of the received coded symbols into the first buffer storage means in accordance with the first address count; and a second address counter for reading symbols out of the first buffer storage means in accordance with a second address count. The second address count is incremented by the control circuit when the determination of the decoding algorithm results in a high likelihood value and decremented when the determination results in a low likelihood value. According to a first embodiment of the invention, the second address count is further incremented by an amount equal to the second predetermined number when the buffer overflow is detected. According to a second embodiment, the second address count is reset so that it equals the first address count when the buffer overflow is detected.

## BRIEF DESCRIPTION OF THE DRAWINGS

The present invention will be described in further detail with reference to the accompanying drawings, in which:

Fig. 1 is a block diagram of a sequential decoder according to a first preferred embodiment of the present invention;

Fig. 2 is a schematic block diagram of the controller of Fig. 1;

Figs. 3a and 3b are illustrations of the read and write address counts of a random access memory of Fig. 1 under normal and overflow conditions, respectively;

Fig. 4 is a block diagram of a sequential decoder according to a second preferred embodiment of the present invention;

Fig. 5 is a schematic diagram of the controller of Fig. 4; and

Figs. 6a and 6b are illustrations of the read and write address counts of a random access memory of Fig. 4 under an initial overflow condition and a subsequent "suboverflow" condition, respectively.

DETAILED DESCRIPTION

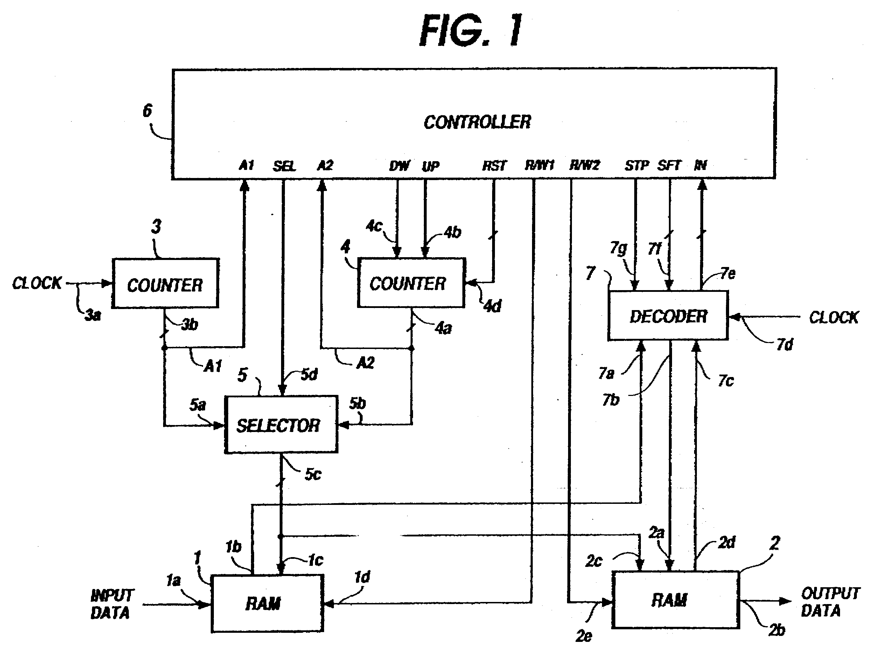

Referring now to Fig. 1, there is shown a sequential decoder according to an embodiment of the present invention. Convolutional codes are modulated upon a carrier and transmitted from a transmit end of a link and received by a demodulator, not shown, at a receive end of the link. The received signal is demodulated to recover the convolutional code symbols. A clock recovery circuit, not shown, recovers clock pulses from the demodulated convolutional codes and feeds them into the input terminal 3a of an "M1-bit" address counter 3 for generating an address signal A1. Address signal A1 is supplied from the output terminal 3b of counter 3 to terminal A1 of a controller 6 and to input terminal 5a of an address selector 5. Selector 5 has a second input terminal 5b to which an address signal A2 from the output terminal 4a of another "M1-bit" address counter 4 is also applied.

Selector 5 is responsive to a switching control signal supplied from a terminal SEL of the controller 6 to selectively couple the input address signals A1 and A2 to its output terminal 5c which is connected to address terminals 1c and 2c of RAMs 1 and 2. RAMs 1 and 2 serve as input and output buffers each having "M1" symbol (or bit) storage locations. The received data bit is fed to an input terminal 1a of RAM 1 and written into a storage location specified by the address signal A1 and read out of the RAM 1 in response to the address signal A2 from counter 4. Data bits stored in RAM 1 are sequentially read out of the locations which are specified by the address signal A2 and fed into a decoder 7 through output terminal 1b and input terminal 7a. The address signal A2 thus represents the location of a symbol in RAM 1 on which decoding is in progress.

Address counter 4 starts incrementing its count from a zero count value in response to a signal received at terminal 4b from UP terminal of the controller 6 and decrements the count in response to a signal received at terminal 4c from DW terminal of the controller 6 and supplies its output to terminal A2 of the controller 6 as well as to the second input 5b of selector 5. As will be described, address counter 4 is reset by a signal received at terminal 4d from RST terminal of the controller 6 to reset its initial value to M2 which is smaller than M1 whenever an overflow condition of RAM 1 is detected by controller 6.

As is well known in the art, the decoder 7 essentially comprises a bidirectional shift register and a plurality of exclusive-OR modulo-2 summers connected to some of the shift register stages in a configuration known as a "replica of the convolutional encoder". The shift register of the decoder 7 is normally shifted forward in response to the completion of a decoding operation on a coded symbol from RAM 1. Decoded symbols sequentially appear at an output terminal 7b and are fed through an input terminal 2a to RAM 2 and sequentially read therefrom and supplied to an external circuit, not shown, through output terminal 2b as output data if no data error occurs in the input data stream. The shift register is shifted backward when decoding is to be repeated on symbols. This is achieved by recalling stored symbols from RAM 2 through output terminal 2d to input terminal 7c of decoder 7 in response to a read enable signal supplied from terminal R/W2 of the controller 6 to input terminal 2e. Decoder 7 receives a clock pulse through terminal 7d. This clock pulse occurs at a rate much higher than the rate of the clock pulse supplied to the counter 3. On completion of a decoding operation on each symbol, two input signals are supplied from terminal 7e to terminal IN of the controller 6. One of these signals represents a decoded symbol and the other the corresponding nondecoded symbol. These signals are compared with each other using the Fano algorithm to determine the Fano likelihood value and hence the distance to the most likelihood path. Read/write enable signals supplied from the controller 6 through terminals R/W1 and R/W2 to terminals 1d and 2e of RAMs 1 and 2, respectively. Decoder 7 is constructed to receive shift and stop command signals respectively at terminals 7f and 7g from terminals SFT and STP of the controller 6 in accordance with the decision of the controller 6 made in accordance with the Fano algorithm.

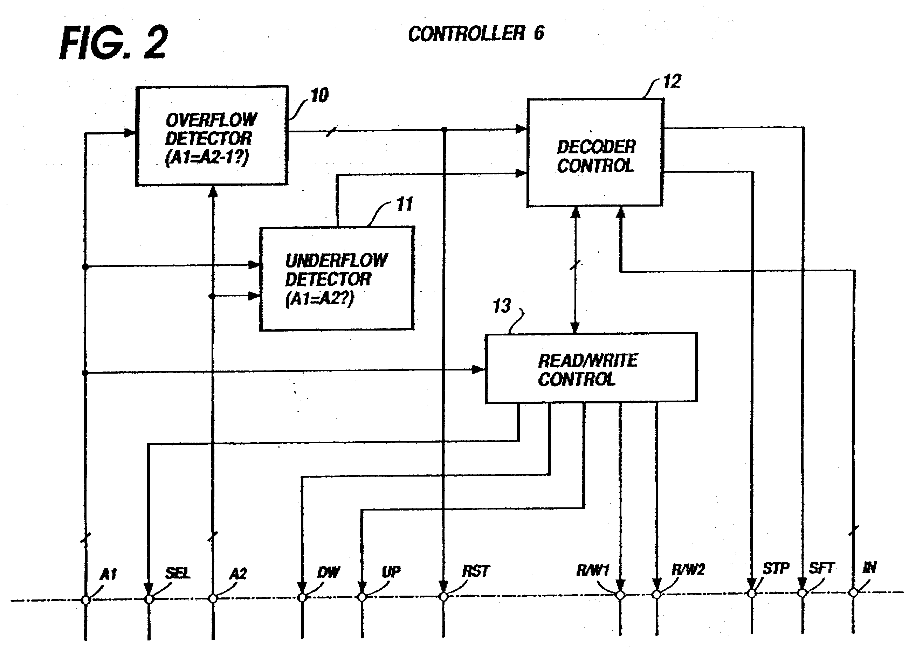

As shown in Fig. 2, the controller 6 essentially comprises an overflow detector 10 which detects when RAM 1 is overflowed and supplies the reset signal mentioned above to the address counter 4. This overflow condition is given when the address count A1 becomes equal to the count A2 minus 1. An underflow detector 11 is provided to detect when RAM 1 is underflowed. The underflow condition exists when the address count A1 becomes equal to the count A2. A decoder controller 12, which implements the Fano algorithm, is arranged to receive signals from the detectors 10 and 11 and signals from the decoder 7 and supplies decoder control signals including forward/backward shift command signals and a stop command signal. A read/write controller 13 is associated with the decoder controller 12 and the counter 3 to supply read/write control signals including the repeat command signal to RAM 2, switching signal to selector 5, up/down count signals to counter 4 to increment or decrement the address count A2 and read/write enable signals to RAMs 1 and 2.

The operation of the sequential decoder of the invention is as follows. In response to the receipt of a fresh symbol, the address counter 3 is Incremented by the corresponding clock pulse, producing an address signal A1 which is applied through selector 5 to RAMs 1 and 2 to write the received fresh symbol into a storage location specified by the address signal A1 and read out a decoded symbol out of the random access memory 2 from a storage location specified by the address signal A1 for delivery to an external circuit.

On decoding a symbol bit, signals are supplied through terminals IN to the controller 6 from the decoder 7. The read/write controller 13 instructs the selector 5 to switch its inputs so that the address signal A2 from counter 4 is supplied to RAMs 1 and 2 instead of address signal A1 and the decoded symbol is written into a location of RAM 2 specified by the address signal A2. Read/write controller 13 supplies a count increment signal through up/count terminal-UP to the counter 4 to read the next symbol from a location of RAM 1 addressed by the incremented address signal A2 and signals this fact to the decoder controller 12. Decoder controller 12 applies a forward shift command signal through terminal SFT to the decoder 7 to cause it to proceeds with decoding the symbol just read out of RAM 1.

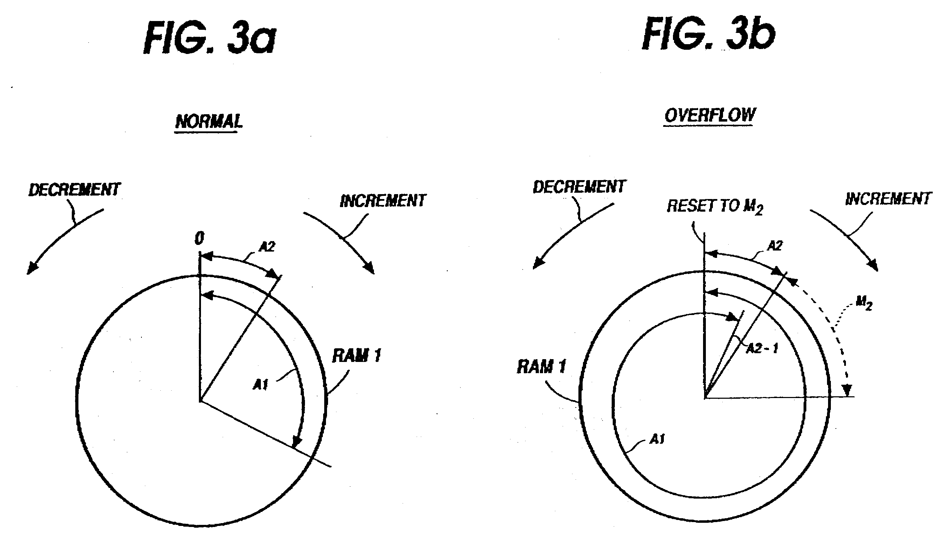

Since the decoding rate is much higher than the rate at which the incoming symbols are received, the address signal $A_2$ will be incremented to such a point approaching the address signal $A_1$ if there is no transmission error (see Fig. 3a). Under such conditions the decoder 7 is in readiness to instantly perform a decoding operation on each fresh symbol as soon as it is received and stored into RAM 1. If this normal condition continues, no symbols will eventually be left in RAM 1 to be decoded. This underflow condition of RAM 1 is detected by the underflow detector 11. When the address counts A1 and A2 become equal to each other, underflow detector 11 communicates this fact to the decoder controller 12 to cause it to supply a stop command signal through terminal STP to the decoder 7.

If a symbol error should occur, the decoder controller 12 supplies a backward shift command signal through terminal SFT to the decoder 7 to cause it to shift backward to retrace the path of the code tree. At the same time, the read/write controller 13 decrements the address counter 4 by one through terminal DW and switches RAM 2 to a read mode to read out previously decoded symbols.

If a serious transmission error or an out-of-sync condition should occur, a substantial amount of delay will be introduced to the decoding process and RAM 1 will be overflowed with symbols and an undesired situation will eventually occur, i.e., some of the previously written symbols are overwritten with newly arrived symbols. When such condition should prevail, the address count A1 will be incremented to such a point approaching the address count A2 as shown in Fig. 3b. When the address count A1 becomes equal to the count A2 minus 1 (which corresponds to a situation in which there is a difference of only one node in the code tree between the symbol just read out of RAM 1 into the decoder 7 and a fresh symbol just written into RAM 1), the overflow detector 10 generates a reset signal through terminal RST to reset the initialized value of the address counter 4 to M2 which is smaller than the maximum address count M1. As a result, the address count A1 is rapidly incremented by M2.

In response to the reset signal from overflow detector 10, the decoder controller 12 supplies a backward shift command through terminal SFT to decoder 7 to shift the timing of the decoder 7 by one coded symbol. In this way, the decoding process restarts with a symbol which is written into RAM 1 by M2 symbols older than the most recently written symbol. If this resetting operation fails and an overflow condition occurs again in RAM 1, the process is repeated. Since no decoding operation proceeds during the time interval between the time at which the counter 4 is reset and the time at which the overflow condition occurs again and such time interval is equal to (M1 - M2) times the interval between successive clock pulses. If each coded symbol is composed of N bits, synchronization can be reestablished by repeating the one-bit shifting of the coded symbol by (N-1) times at most as will be understood from the description given above.

As compared with the prior art in which the amount of time necessary to detect an overflow condition is M1 times the intervals of recovered clock pulses, this time interval is reduced to (M1 - M2) in the present invention, thus the maximum amount of time taken by the sequential decoder of the invention to resynchronize is reduced by a factor (M1 - M2)/M1. Therefore, the number of symbols which must be discarded during a resynchronization can be reduced to M1 - M2 - 1.

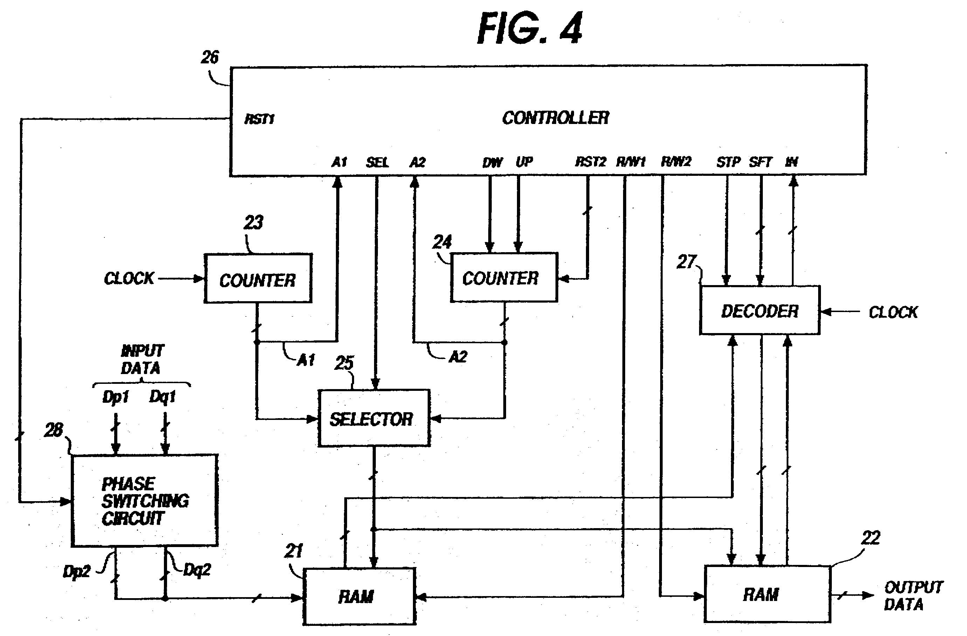

A modified embodiment of the present invention is shown in Fig. 4. In this modification, 4-bit/symbol convolutional codes are transmitted on a 16QAM (quadrature amplitude modulation) system having a code rate 3/4. Received modulated codes are demodulated by a 16-QAM demodulator into a pair of in-phase (P-channel) and out-of-phase (Q-channel) signals each having one of four different amplitude levels which correspond respectively to the four phases on each axis of the phase diagram. Each of these signals is converted to a two-bit signal by comparison with hard-decision thresholds in a well known manner by means of an analog-to-digital converter, not shown. The two-bit I and Q signals, which comprise a symbol, are supplied as Dp1 and Dq1 to a phase switching circuit 28. Phase switching circuit 28 converts the logic states of the input two-bit signals so that it compensates for phase errors introduced to the reference carrier recovered by the demodulator. The conversion of one logic state to another is a quantum step corresponding to a phase shift of 90 degrees. Thus, successive logic state conversions result in phase shifts of 180 and 270 degrees. The two-bit outputs of the phase switching circuit 28 are combined into a 4-bit output and fed to a RAM 21 for storing a maximum of N 4-bit symbols. Each 4-bit symbol is written into a storage location of RAM 1 specified by an address signal A1 supplied from an N-bit address counter 23 through a selector 25. As in the previous embodiment, the address counter 23 is incremented in response to each of the recovered clock pulses. Stored 4-bit symbols are read out of RAM 21 into a decoder 27 in response to an address signal A2 supplied from an N-bit address counter 24 which is incremented or decremented by a signal from a controller 26. To control the read/write modes of the RAMs 21 and 22, controller 26 receives a signal through terminal A1 to cause the selector 25 to switch its output to the input from counter 23 in response to each increment of the address count A1 and switches RAM 21 through read/write enable terminal R/W1 to a write mode to store a fresh symbol into the location specified by count A1 and switches RAM 22 to a read mode through read/write enable terminal R/W2 to read out a stored decoded symbol from a location specified by the address count A1 for delivery to an external circuit. On decoding a symbol, decoder 27 supplies signals to controller 26 to cause it to switch RAM 21 to a read mode and RAM 22 to a write mode and switches the selector 25 to supply address count A2 to the RAMs 21 and 22, whereby the decoded symbol is written into RAM 22. Address count A2 is then incremented to read the next symbol from RAM 21 into the decoder 27. Whenever there is a high likelihood of an error, the counter 24 is decremented through terminal DW by controller 26 to repeat the decoding operation on previously decoded symbols.

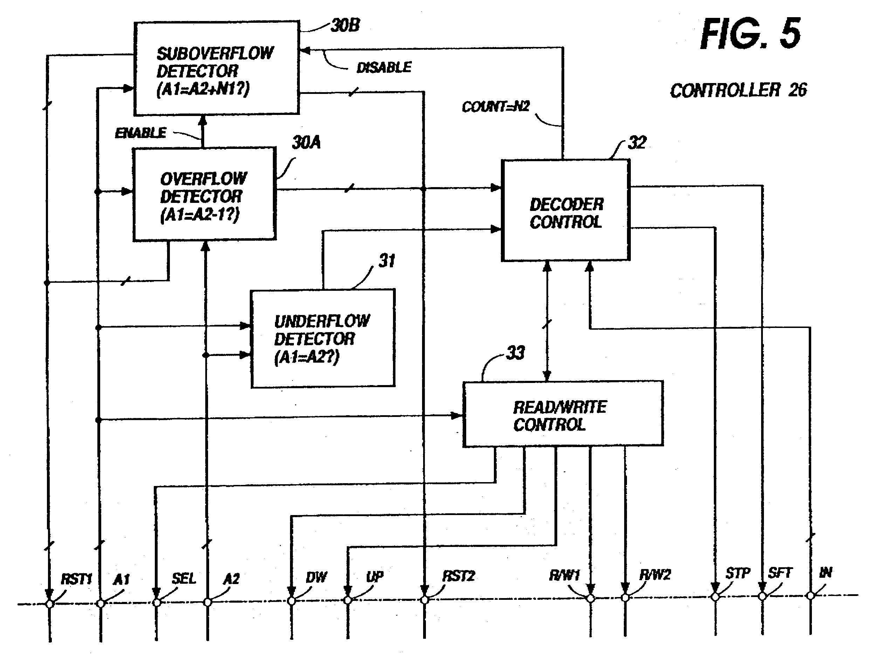

As shown in Fig. 5, the controller 26 is generally similar to the controller 6 of Fig. 2 with the exception that it further includes a suboverflow detector 30B in addition to the overflow detector 30A which is identical to overflow detector 10 of Fig. 2. Elements 31, 32 and 33 correspond respectively to elements 11, 12 and 13 of Fig. 2. Overflow detector 30A detects when the address signal A1 is equal to address count A2 minus 1 to supply a first reset signal through reset terminal RST1 to the phase switching circuit 28 and a second reset signal to the address counter 24 through reset terminal RST2. The first reset signal causes the phase switching circuit 28 to switch the logic states of the binary quadrature signals so that the converted logic states correspond to a phase which is shifted by a predetermined amount with respect to the phase of the input signals. The second reset signal is to reset the address count value A2 equal to the address count A1. Overflow detector 30A further supplies an enable signal to the suboverflow detector 30B when it detects an overflow condition in RAM 21. Suboverflow detector 30B is rendered active in response to the enable signal from overflow detector 30A to detect if a "suboverflow" condition occurs in RAM 21, i.e., RAM 21 is filled with symbols smaller than its capacity. This "suboverflow" condition occurs when the address count A1 becomes equal to A2 + N1 (where N1 is typically 1/10 of the number of the address locations N of RAM 21). Suboverflow detector 30B generates the first and second reset signals in a manner identical to those generated by the overflow detector 30A. Decoder controller 32 responds to the second reset signals from detectors 30A and 30B to initiate counting symbols which have been decoded by decoder 27 and disables the suboverflow detector 30B when the count reaches N2 which is much smaller than N.

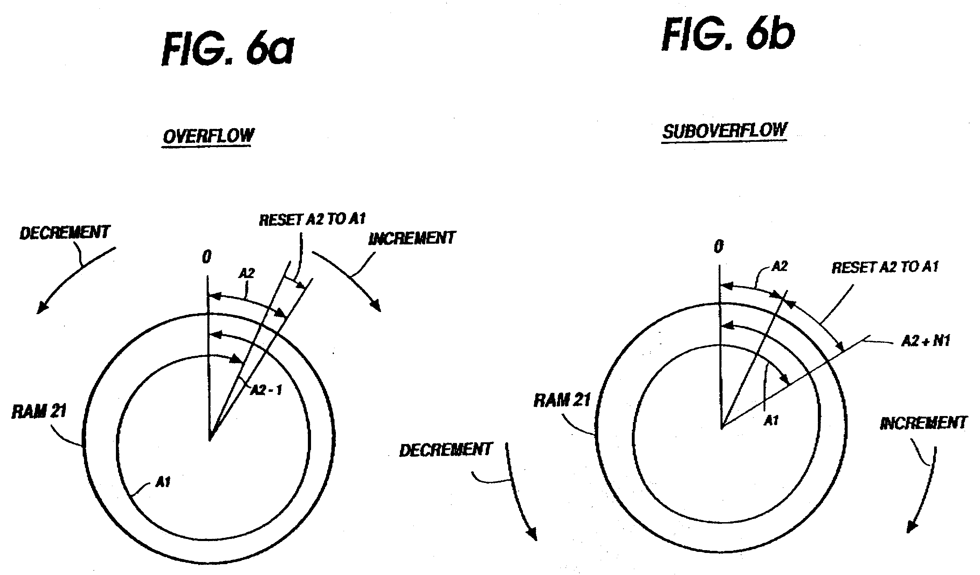

Therefore, if an overflow condition of RAM 21 occurs as a result of phase errors introduced to the reference carrier, the address count A1 becomes equal to A2 - 1 and the overflow detector 30A of controller 26 detects this condition and supplies a first reset signal through terminal RST1 to the phase switching circuit 28. The logic state of one or both of the incoming two-bit signals Dp1 and Dq1 is converted so that the 4-bit output symbol is advanced by 90 degrees with respect to the incoming symbol. The reset logic states are maintained until they are reset again. Simultaneously with the resetting of phase switching circuit 28, a second reset signal is supplied from the overflow detector 30A through terminal RST2 to the address counter 24 to reset its count equal to the address count A1 of counter 23 (Fig. 6a). As in the previous embodiment, a shift command signal is applied to the decoder 27 through terminal SFT to shift the sync timing by one clock interval. If these resetting operations is not effective in completely compensating for the phase error, RAM 21 will be again filled with a growing number of unprocessed symbols. Since the suboverflow detector 30B is enabled by the overflow detector 30A, a "suboverflow" condition will be detected when A1 becomes equal to A2 + N1 (see Fig. 6b). The phase switching circuit 28 is set to introduce another 90 degree phase shift to the incoming digital signals, giving a phase shift with a total of 180 degrees and the address counter 24 is again reset equal to A1. It will be seen that the initial and subsequent resetting operations will be performed a total of three times to correct phase errors of the worst case. If the initial or subsequent resetting operations are effective in correcting phase errors, the number of successfully decoded symbols will increase and the decoder controller 32 judges that the phase error has been corrected as it counts the preselected number (=N2) of validly decoded symbols when the determination by the Fano algorithm derives a high likelihood value and supplies a disable signal to suboverflow detector 30B.

## Claims

1. A sequential decoder for decoding convolutionally coded symbols received at a transmission rate of the symbols comprising first and second buffer storage means (1, 2; 21, 22), a decoder (7; 27) coupled to said first and second buffer storage means (1, 2; 21, 22) for receiving a symbol supplied bidirectionally from said first and second buffer storage means and decoding the supplied symbol in synchronism with a clock pulse occurring at a rate higher than said transmission rate, address means (3, 4, 5; 23, 24, 25) for storing the received convolutionally coded symbols into said first buffer storage means (1; 21) at said transmission rate, reading symbols out of said first buffer storage means (1; 21) into said decoder (7; 27) and storing symbols decoded by said decoder (7; 27) into said second buffer storage means (2; 22) and control means (6; 26) for determining the likelihood of each symbol decoded by said decoder (7; 27) in accordance with a predetermined likelihood algorithm causing said address means (3, 4, 5; 23, 24, 25) to read decoded symbols in a backward direction out of said second buffer storage means (2; 22) into said decoder (7; 27) when the determination results in a low likelihood value, and detecting an overflow condition of said first buffer storage means (1; 21) when a first predetermined number M1 of locations thereof are filled with the received symbols, characterized in that said control means (6; 26) includes means (10, 11, 13; 30, 31, 33) for causing said address means (3, 4, 5; 23, 24, 25) to read symbols out of said first buffer storage means (1; 21) into said decoder starting with a symbol spaced by M1-M2 symbols from a most recently received symbol and means (12; 22) for causing said decoder (7; 27) to repeatedly perform decoding, upon detection of the overflow condition, on a symbol which is shifted by one clock interval, where M2 is a second predetermined number which is smaller than said first predetermined number M1.

2. A sequential decoder as claimed in claim 1, characterized in that said address means comprises a first address counter (3) for incrementing a first address count in response to receipt of each of said convolutionally coded symbols and storing each of the received coded symbols into said first buffer storage means (1) in accordance with said first address count, and a second address counter (4) for varying a second address count in response to a control signal from said control means (6) and reading symbols out of said first buffer storage means (1) in accordance with said second address count, and in that said control means includes said means (10, 12, 13) for generating said control signal to increment said second address count when said determination indicates a high likelihood value and decrementing said second address count when said determination indicates a low likelihood value, said control means (6) being responsive to the detection of said overflow condition for resetting said second address counter (4) equal to a value corresponding to a location of said first buffer storage means (1) which is shifted by M1-M2 symbols from a position in which the most recently received symbol is stored.

3. A sequential decoder as claimed in claim 1, characterized in that a phase switching circuit (28) is connected to the input of said first buffer storage means (21), and in that said control means (26) includes suboverflow detector means (30B) for detecting a suboverflow condition of said first buffer storage means (21) when a first predetermined number of locations thereof are filled with the received symbols, overflow detector means (30A) for detecting an overflow condition of said first buffer storage means (21) when a second predetermined number of locations thereof are filled with the received symbols, causing said address means (23, 24) to read symbols out of said first buffer storage means (21) into said decoder (27) starting with the most recently received symbol when said overflow condition is detected by said overflow detector means (30A), and varying logic level of symbols received by said phase switching circuit (28) by an amount corresponding to a predetermined amount of phase shift in response to the detection of each of said suboverflow condition and said overflow condition.

4. A sequential decoder as claimed in claim 3, characterized in that said predetermined amount of phase shift corresponds to a submultiple of 360 degrees.

5. A sequential decoder as claimed in claim 3 or 4, characterized in that said address means comprises a first address counter (23) for incrementing a first address count in response to receipt of each of said convolutionally coded symbols and storing each of the received coded symbols into said first buffer storage means in accordance with said first address count, and a second address counter (24) for varying a second address count in response to a control signal from said control means and reading symbols out of said first buffer storage means in accordance with said second address count, and in that said control means (26) includes means for generating said control signal to increment said second address count when said determination indicates a high likelihood value and decrementing said second address count when said determination indicates a low likelihood value, and in that said control means (26) is responsive to the detection of said suboverflow condition for resetting said second address counter (24) equal to a value corresponding to a location of said first buffer storage means (21) which is shifted by M1-M2 symbols from a position in which the most recently received symbol is stored and is further responsive to the detection of an overflow condition by said overflow detector means (30A) for resetting said second address counter (24) to a value equal to a location of said first buffer storage means (21) in which the most recently received symbol is stored.

**Patentansprüche**

1. Ein Folgedecoder zur Decodierung von konvolutionell codierten Symbolen, die mit einer Übertragungsrate der Symbole empfangen werden, der eine erste und eine zweite Pufferspeichereinrichtung (1, 2; 21, 22), einen Decoder (7; 27), der mit der ersten und der zweiten Pufferspeichereinrichtung (1, 2; 21, 22) zum Empfang eines Symbols verbunden ist, das bidirektional von der ersten und der zweiten Pufferspeichereinrichtung zugeführt wird, und zur Decodierung des zugeführten Symbols synchron mit einem Taktimpuls, der mit einer Rate höher als die Übertragungsrate auftritt, Adressiereinrichtungen (3, 4, 5; 23, 24, 25) zur Speicherung der empfangenen konvolutionell codierten Symbole in der ersten Pufferspeichereinrichtung (1; 21) mit der Übertragungsrate, wobei Symbole aus der ersten Pufferspeichereinrichtung (1; 21) in den Decoder (7; 27) ausgelesen werden und die durch den Decoder (7; 27) decodierten Symbole in der zweiten Pufferspeichereinrichtung (2; 22) gespeichert werden, und eine Steuereinrichtung (6; 26) zur Ermittlung der Wahrscheinlichkeit jedes Symbols aufweist, das durch den Decoder (7; 27) decodiert wird, und zwar in Abhängigkeit eines vorgegebenen Wahrscheinlichkeits-Algorithmus, der bewirkt, daß die Adressiereinrichtungen (3, 4, 5; 23, 24, 25) decodierte Symbole in einer Rückwärtsrichtung aus der zweiten Pufferspeichereinrichtung (2; 22) in den Decoder (7; 27) einlesen, wenn die Ermittlungsergebnisse zu einem niedrigen Wahrscheinlichkeitswert führen, und wobei ein Überlaufzustand der ersten Pufferspeichereinrichtung (1; 21) ermittelt wird, wenn eine erste vorgegebene Zahl M1 von Stellen davon mit den empfangenen Symbolen aufgefüllt sind, gekennzeichnet dadurch, daß die Steuereinrichtung (6; 26) Einrichtungen (10, 11, 13; 30, 31, 33) aufweist, um zu bewirken, daß die Adressiereinrichtungen (3, 4, 5; 23, 24, 25) Symbole aus der ersten Pufferspeichereinrichtung (1; 21) zu dem Decoder hin auslesen, wobei mit einem Symbol gestartet wird, das um M1-M2 Symbole von einem am kürzesten vorher empfangenen Symbol beabstandet ist, und das Einrichtungen (12; 22) zum Bewirken, daß der Decoder (7; 27) wiederholt das Decodieren durchführt, aufweist, und zwar unter Ermittlung eines Überlaufzustands, und zwar auf einem Symbol, das um ein Taktintervall verschoben ist, wobei M2 eine zweite vorgegebene Zahl ist, die kleiner als die erste vorgegebene Zahl M1 ist.

2. Folgedecoder nach Anspruch 1, dadurch gekennzeichnet, daß die Adressiereinrichtungen einen ersten Adressenzähler (3) zum Erhöhen eines ersten Adressenzählwerts in Abhängigkeit des Empfangs jedes der konvolutionell codierten Symbole aufweist, und wobei jeder der empfangenen codierten Symbole in der ersten Pufferspeichereinrichtung (1) entsprechend dem ersten Adressenzählwert gespeichert wird, und einen zweiten Adressenzähler (4) zum Variieren eines zweiten Adressenzählwerts in Abhängigkeit eines Steuersignals von der Steuereinrichtung (6) aufweist, und wobei Symbole der ersten Pufferspeichereinrichtung (1) entsprechend dem zweiten Adressenzählwert ausgelesen werden, und daß die Steuereinrichtung Einrichtungen (10, 12, 13) zum Erzeugen des Steuersignals aufweist, um den zweiten Adressenzählwert zu erhöhen, wenn die Ermittlung einen hohen Wahrscheinlichkeitswert anzeigt, und zur Herabsetzung des zweiten Adressenzählwerts, wenn die Ermittlung einen niedrigen Wahrscheinlichkeitswert anzeigt, wobei die Steuereinrichtungen (6) auf die Ermittlung des Überlaufzustands zum Zurücksetzen des zweiten Adressenzählers (4) gleich einem Wert einer Stelle der ersten Pufferspeichereinrichtung (1) ansprechen, der um M1 - M2 Symbole von einer Stelle verschoben wird, in der das zuletzt empfangene Symbol gespeichert ist.

3. Folgedecoder nach Anspruch 1, dadurch gekennzeichnet, daß ein Phasenumschaltschaltkreis (28) mit dem Eingang der ersten Pufferspeichereinrichtung (21) verbunden ist und daß die Steuereinrichtung (26) eine Unter-Überlaufdetektoreinrichtung (30B) zur Ermittlung eines Unter-Überlaufzustands der ersten Pufferspeichereinrichtung (21), wenn eine erste vorgegebene Anzahl von Stellen davon mit den empfangenen Symbolen aufgefüllt ist, eine Überlaufdetektoreinrichtung (30A) zur Ermittlung eines Überlaufzustands der ersten Pufferspeichereinrichtung (21), wenn eine zweite vorgegebene Zahl von Stellen davon mit den empfangenen Symbolen aufgefüllt ist, aufweist, wodurch bewirkt wird, daß die Adressiereinrichtungen (23, 24) Symbole aus der ersten Pufferspeichereinrichtung (21) heraus in den Decoder (27) einliest, wobei mit dem zuletzt empfangenen Symbol begonnen wird, wenn der Überlaufzustand durch die Überlaufdetektoreinrichtung (30A) ermittelt wird, und wobei der logische Pegel der Symbole, die durch den Phasenumschaltschaltkreis (28) mit einem Wert entsprechend einem vorgegebenen Wert der Phasenverschiebung in Abhängigkeit der Ermittlung jedes des Unter-Überlaufzustands und des Überlaufzustands empfangen wird, variiert wird.

4. Folgedecoder nach Anspruch 3, dadurch gekennzeichnet, daß der vorgegebene Wert der Phasenverschiebung einem Teilvielfachen von 360 Grad entspricht.

5. Folgedecoder nach Anspruch 3 oder 4, dadurch gekennzeichnet, daß die Adressiereinrichtung einen ersten Adressenzähler (23) zur Erhöhung eines ersten Adressenzählwerts in Abhängigkeit des Empfangs jedes der konvolutionell codierten Symbole und zur Speicherung jedes der empfangenen, codierten Symbole in der ersten Pufferspeichereinrichtung entsprechend dem ersten Adressenzählwert und einen zweiten Adressenzähler (24) zur Variation eines zweiten Adressenzählwerts in Abhängigkeit eines Steuersignals von der Steuereinrichtung aufweist, und wobei Symbole aus der ersten Pufferspeichereinrichtung entsprechend dem zweiten Adressenzählwert ausgelesen werden, und daß die Steuereinrichtung (26) Einrichtungen zum Erzeugen des Steuersignals aufweist, um den zweiten Adressenzählwert zu erhöhen, wenn die Ermittlung einen hohen Wahrscheinlichkeitswert anzeigt, und wobei der zweite Adressenzählwert erniedrigt wird, wenn die Ermittlung einen niedrigen Wahrscheinlichkeitswert anzeigt, und daß die Steuereinrichtung (26) auf die Ermittlung des Unter-Überlaufzustands zum Zurücksetzen des zweiten Adressenzählers (24) gleich einem Wert entsprechend einer Stelle der ersten Pufferspeichereinrichtung (21), die um M1-M2 Symbole von einer Stelle aus verschoben wird, in der das zuletzt empfangene Symbol gespeichert ist, anspricht, und die weiterhin auf die Ermittlung eines Überlaufzustands durch die Überlaufermittlungseinrichtung (30A) zum Zurücksetzen des zweiten Adressenzählers (24) auf einen Wert gleich einer Stelle der ersten Pufferspeichereinrichtung (21) anspricht, in der das zuletzt empfangene Symbol gespeichert ist.

**Revendications**

1. Décodeur séquentiel pour décoder des symboles convolutionnellement codés reçus à une vitesse de transmission des symboles comprenant des premier et second moyens de mémoire tampon (1, 2 ; 21, 22), un décodeur (7 ; 27) couplé aux premier et second moyens de mémoire tampon (1, 2 ; 21, 22) pour recevoir un symbole délivré bidirectionnellement à partir des premier et second moyens de mémoire tampon et pour décoder le symbole délivré en synchronisme avec une impulsion d'horloge se produisant à une vitesse plus élevée que la vitesse de transmission, un moyen d'adresse (3, 4, 5 ; 23, 24, 25) pour mémoriser les symboles reçus convolutionnellement codés dans le premier moyen de mémoire tampon (1 ; 21) à la vitesse de transmission, pour extraire les symboles du premier moyen de mémoire tampon (1 ; 21) et les placer dans le décodeur (7 ; 27) et pour mémoriser les symboles décodés par le décodeur (7 ; 27) dans le second moyen de mémoire tampon (2 ; 22) et un moyen de commande (6 ; 26) pour déterminer la vraisemblance de chaque symbole décodé par le décodeur (7 ; 27) en conformité avec un algorithme de vraisemblance prédéterminé amenant ledit moyen d'adresse (3, 4, 5 ; 23, 24, 25) à renvoyer les symboles décodés du second moyen de mémoire tampon (2 ; 22) dans le décodeur (7 ; 27) lorsque la détermination a pour résultat une valeur de vraisemblance faible, et pour détecter une condition de débordement du premier moyen de mémoire tampon (1 ; 21) lorsqu'un premier nombre prédéterminé M1 d'emplacements dans celui-ci sont remplis avec les symboles reçus, caractérisé en ce que le moyen de commande (6 ; 26) comporte un moyen (10, 11, 13 ; 30, 31, 33) pour amener le moyen d'adresse (3, 4, 5 ; 23, 24, 25) à lire les symboles dans le premier moyen de mémoire tampon (1 ; 21) et les placer dans le décodeur commençant avec un symbole espacé par M1-M2 symboles à partir du symbole reçu le plus récemment et un moyen (12 ; 22) pour amener le décodeur (7 ; 27) à effectuer de manière répétée le décodage, sur détection d'une condition de débordement, sur un symbole qui est décalé d'un intervalle d'horloge, où M2 est un second nombre prédéterminé qui est inférieur au premier nombre prédéterminé M1.

2. Décodeur séquentiel selon la revendication 1, caractérisé en ce que le moyen d'adresse comprend un premier compteur d'adresses (3) pour incrémenter un premier compte d'adresses en réponse à la réception de chacun des symboles convolutionnellement codés et pour mémoriser chacun des symboles codés reçus dans le premier moyen de mémoire tampon (1) en conformité avec le premier compte d'adresses, et un second compteur d'adresses (4) pour faire varier un second compte d'adresses en réponse à un signal de commande provenant du moyen de commande (6) et pour extraire les symboles du premier moyen de mémoire tampon (1) en conformité avec le second compte d'adresses, et en ce que le moyen de commande comporte le moyen (10, 12, 13) pour produire le signal de commande afin d'incrémenter le second compte d'adresses lorsque la détermination indique une valeur de vraisemblance élevée et pour décrémenter le second compte d'adresses lorsque la détermination indique une valeur de vraisemblance faible, le moyen de commande (6) étant sensible à la détection de la condition de débordement pour réinitialiser le second compteur d'adresses (4) égal à une valeur correspondant à un emplacement du premier moyen de mémoire tampon (1) qui est décalé de M1-M2 symboles à partir d'un emplacement dans lequel le symbole reçu le plus récemment est mémorisé.

3. Décodeur séquentiel selon la revendication 1, caractérisé en ce qu'un circuit de commutation de phase (28) est connecté à l'entrée du premier moyen de mémoire tampon (21), et en ce que le moyen de commande (26) comporte un moyen de détecteur de sous-débordement (30B) pour détecter une condition de sous-débordement de la première mémoire tampon (21) lorsqu'un premier nombre prédéterminé d'emplacements de celle-ci sont remplis avec des symboles reçus, un moyen de détection de débordement (30A) pour détecter une condition de débordement du premier moyen de mémoire tampon (21) lorsqu'un second nombre prédéterminé d'emplacements de celle-ci sont remplis avec les symboles reçus, amenant le moyen d'adresse (23, 24) à extraire les symboles du premier moyen de mémoire tampon (21) et les placer dans le décodeur (27) commençant avec le symbole reçu le plus récemment lorsque la condition de débordement est détectée par le moyen de détection de débordement (30A) et faire varier le niveau logique des symboles reçus par le circuit de commutation de phase (28) d'une quantité correspondant à une quantité prédéterminée de déphasage en réponse à la détection de chacune des conditions de sous-débordement et de conditions de débordement.

4. Décodeur séquentiel selon la revendication 3, caractérisé en ce que la valeur prédéterminée du déphasage correspond à un sous-multiple de 360 degrés.

5. Décodeur séquentiel selon la revendication 3 ou 4, caractérisé en ce que le moyen d'adresse comprend un premier compteur d'adresses (23) pour incrémenter un premier compte d'adresses en réponse à la réception de chacun des symboles convolutionnellement codés et pour mémoriser chacun des symboles codés reçus dans le premier moyen de mémoire tampon en conformité avec le premier compte d'adresses, et un second compteur d'adresses (24) pour faire varier un second compte d'adresses en réponse à un signal de commande provenant du moyen de commande et pour extraire les symboles du premier moyen de mémoire tampon en conformité avec le second compte d'adresses, et en ce que le moyen de commande (26) comporte un moyen pour produire le signal de commande pour incrémenter le second compte d'adresses lorsque la détermination indique une valeur de vraisemblance élevée et pour décrémenter le second compte d'adresses lorsque ladite détermination indique une valeur de vraisemblance faible, et en ce que le moyen de commande (26) est sensible à la détection d'une condition de sous-débordement pour réinitialiser le second compteur d'adresses (24) égal à une valeur correspondant à un emplacement du premier moyen de mémoire tampon (21) qui est décalé de M1-M2 symboles à partir d'un emplacement dans lequel le symbole reçu le plus récemment est mémorisé et est de plus sensible à la détection d'une condition de débordement par le moyen de détection de débordement (30A) pour réinitialiser le second compteur d'adresses (24) à une valeur égale à un emplacement du premier moyen de mémoire tampon (21) dans lequel le symbole reçu le plus récemment est mémorisé.

# FIG. 1

EP 0 302 511 B1

**FIG. 2**

CONTROLLER 6

OVERFLOW DETECTOR (A1=A2-1?) — 10

UNDERFLOW DETECTOR (A1=A2?) — 11

DECODER CONTROL — 12

READ/WRITE CONTROL — 13

A1  SEL  A2  DW  UP  RST  R/W1  R/W2  STP  SFT  IN

EP 0 302 511 B1

FIG. 3a

FIG. 3b

# FIG. 4

EP 0 302 511 B1

FIG. 5

CONTROLLER 26

# FIG. 6a

OVERFLOW

# FIG. 6b

SUBOVERFLOW

EP 0 302 511 B1